# EUROPEAN PATENT APPLICATION

(11) **EP 3 442 034 A1**
(43) Date of publication of application: **13.02.2019**
(21) Application number: 17896328.6
(22) Date of filing: 29.12.2017
(51) Int. Cl.: H01L 31/048, H01L 31/18

(54) **THIN-FILM DOUBLE GLASS PHOTOVOLTAIC MODULE AND MANUFACTURING METHOD THEREFOR**

(30) Priority: 19.05.2017 CN 201710359343
(71) Applicant: Miasole Photovoltaic Technology Co., Ltd., Beijing (CN)
(72) Inventor: ZHANG, Jinchun, Beijing 100070 (CN)
(74) Representative: Cabinet Beau de Loménie
(86) International application number: PCT/CN2017/119661
(87) International publication number: WO 2018/209964

(57) **Abstract**

The present disclosure provides a thin-film double-glazed photovoltaic module and a fabrication method thereof. The thin-film double-glazed photovoltaic module includes: back glass, front plate glass, and a thin-film cell stack. A hollow cavity is formed between the back glass and the front plate glass by means of a spacing strip, and the thin-film cell stack is arranged in the hollow cavity. The spacing strip is provided with a metal wire, and the metal wire is consistent with the spacing strip in direction. According to the thin-film double-glazed photovoltaic module and the fabrication method thereof provided by the present disclosure, by forming the hollow cavity between the back glass and the front plate glass, it is ensured that the thin-film cell stack is not squeezed by the back glass and the front plate glass, such that stretching or damaging the thin-film cell stack due to expansion caused by heat and contraction caused by cold of the back glass and the front plate glass is avoided, and thus the service life of the thin-film cell stack is prolonged.

## Description

### TECHNICAL FIELD

The present disclosure relates to the field of solar cell technologies, and more particularly, to a thin-film double-glazed photovoltaic module and a fabrication method thereof.

### BACKGROUND

With the development of solar cell technologies, photovoltaic modules made up of CIGS thin-film cells are more and more widely used. Two sides of an existing CIGS thin-film cell are provided with encapsulation films, and then the CIGS thin-film cell is encapsulated by using two pieces of glass.

In the prior art, when the temperature rapidly changes, expansion caused by heat and contraction caused by cold in encapsulation layers and front and rear glass may apply tension and compression to film layers of the CIGS thin-film cells, and thus the service lives of the photovoltaic modules are affected.

### SUMMARY

An objective of the present disclosure is to provide a thin-film double-glazed photovoltaic module and a fabrication method thereof to solve the problems in the prior art, so as to prevent a CIGS thin-film cell from being damaged due to expansion caused by heat and contraction caused by cold in an encapsulation layer when temperature changes.

The present disclosure provides a thin-film double-glazed photovoltaic module, which includes: back glass, front plate glass, and a thin-film cell stack. A hollow cavity is formed between the back glass and the front plate glass by means of a spacing strip, and the thin-film cell stack is arranged in the hollow cavity. The spacing strip is provided with a metal wire, and the metal wire is consistent with the spacing strip in direction.

In the aforementioned thin-film double-glazed photovoltaic module, preferably, the spacing strip is a butyl rubber strip.

In the aforementioned thin-film double-glazed photovoltaic module, preferably, the metal wire coats inside the butyl rubber strip.

In the aforementioned thin-film double-glazed photovoltaic module, preferably, the metal wire is a steel wire having a diameter of 0.5mm-1.5mm.

Preferably, the aforementioned thin-film double-glazed photovoltaic module further includes a hollow tube. A central axis of the hollow tube is unparallel to the direction of the spacing strip, and ports at two ends of the hollow tube are exposed to two sides of the spacing strip, such that a port at one end of the hollow tube is positioned inside the hollow cavity, and a port at the other end of the hollow tube is positioned outside the hollow cavity.

In the aforementioned thin-film double-glazed photovoltaic module, preferably, the hollow tube passes through the spacing strip, and the hollow tube does not cross over the metal wire.

In the aforementioned thin-film double-glazed photovoltaic module, preferably, the hollow tube has an inside diameter of 2mm and a length of 30mm.

In the aforementioned thin-film double-glazed photovoltaic module, preferably, a material of the hollow tube is polyethylene.

Preferably, the aforementioned thin-film double-glazed photovoltaic module further includes a support ball arranged in the hollow cavity.

In the aforementioned thin-film double-glazed photovoltaic module, preferably, the support ball is a cross-linking or thermosetting microspheric colloidal particle made from polyolefin elastomer (POE) or ethylene-vinyl acetate copolymer (EVA) and having a diameter of 2mm-4mm.

Preferably, the aforementioned thin-film double-glazed photovoltaic module further includes a bus bar and a junction box. An insulating encapsulation film is arranged between a backlight surface of the thin-film cell stack and the bus bar, one end of the bus bar conductively connects to a group of the thin-film cell stacks, and the other end of the bus bar goes through the hollow cavity and then connects to the junction box.

In the aforementioned thin-film double-glazed photovoltaic module, preferably, the bus bar goes out of the hollow cavity via an exit, and the exit is positioned on the back glass, or the exit is positioned between the back glass and the front plate glass.

The present disclosure also provides a method for fabricating a thin-film double-glazed photovoltaic module, which includes the following steps:
Step S100: flat placing front plate glass, and arranging a spacing strip around a side where the front plate glass is upward;
Step S200: placing a thin-film cell stack onto the front plate glass, and keeping a light receiving face of the thin-film cell stack facing toward the front plate glass;
Step S300: covering the back glass on the thin-film cell stack; and
Step S400: laminating by a laminating machine to form the thin-film double-glazed photovoltaic module.

In the aforementioned method for fabricating a thin-film double-glazed photovoltaic module, preferably, the Step S300 specifically includes:
Step S110: flat placing the front plate glass, arranging a spacing strip around a side where the front plate glass is upward, and also placing a metal wire consistent with the spacing strip in direction on the spacing strip.

In the aforementioned method for fabricating a thin-film double-glazed photovoltaic module, preferably, after the Step S110, the method further includes:
Step S120: pre-burying a hollow tube into the spacing strip, and ensuring ports at two ends of the hollow tube are exposed to two sides of the spacing strip, and the hollow tube does not cross over the metal wire.

In the aforementioned method for fabricating a thin-film double-glazed photovoltaic module, preferably, before the Step S100, the fabrication method further includes a process of fabricating a thin-film cell stack, specifically including:
Step S01: connecting in series and laminating a plurality of thin-film cells;
Step S02: arranging an insulating encapsulation film on a backlight surface of the laminated thin-film cells; and
Step S03: pasting a bus bar onto the insulating encapsulation film.

In the aforementioned method for fabricating a thin-film double-glazed photovoltaic module, preferably, the Step S300 specifically includes:
Step S310: threading the bus bar out of an exit, then covering the back glass on the thin-film cell stack;
Step S320: filling with glue at the exit; and
Step S330: connecting the bus bar to the junction box, and filling a seal gum onto the junction box.

In the aforementioned method for fabricating a thin-film double-glazed photovoltaic module, preferably, after the Step S400, the fabrication method further includes:
Step S500: vacuumizing the hollow cavity between the front plate glass and the back glass.

In the aforementioned method for fabricating a thin-film double-glazed photovoltaic module, preferably, after the Step S500, the fabrication method further includes Step S600: injecting nitrogen into the hollow cavity.

In the aforementioned method for fabricating a thin-film double-glazed photovoltaic module, preferably, after the Step S200 and before the Step S300, the fabrication method further includes:
Step S210: arranging a plurality of support balls at a clearance of the thin-film cell stack.

According to the thin-film double-glazed photovoltaic module and the fabrication method thereof provided by the present disclosure, by arranging a thin-film cell stack into the hollow cavity formed between the back glass and the front plate glass, it is ensured that the thin-film cell stack is not squeezed by the back glass and the front plate glass, such that stretching or damaging the thin-film cell stack due to expansion caused by heat and contraction caused by cold of the back glass and the front plate glass is avoided, and thus the service life of the thin-film cell stack is prolonged. In the meanwhile, by arranging a metal wire in the spacing strip, the back glass can be further isolated from the front plate glass, and thus it is ensured that the thin-film cell stack in the hollow cavity is not damaged.

Further, by pre-burying a hollow tube, vacuumization and nitrogen injection operations for the hollow cavity may be implemented, thereby avoiding oxidation of the thin-film cell stack.

Further, by arranging a support ball in the hollow cavity, the back glass is further isolated from the front plate glass, and thus it is ensured that the thin-film cell stack in the hollow cavity is not damaged.

### BRIEF DESCRIPTION OF THE DRAWING

FIG. 1 is a structural diagram of a thin-film double-glazed photovoltaic module according to Embodiment I of the present disclosure;
FIG. 2 is a schematic structural diagram of the thin-film double-glazed photovoltaic module with front plate glass hidden according to Embodiment I of the present disclosure;
FIG. 3 is an enlarged view of Part A in FIG. 2;
FIG. 4 is a schematic structural diagram of a single thin-film cell;
FIG. 5 is a schematic structural diagram of back glass provided with a spacing strip, a metal wire and a hollow tube;
FIG. 6 is an enlarged view of Part B in FIG. 5;
FIG. 7 is an enlarged view of Part C in FIG. 5; and
FIG. 8 is a rear view of the thin-film double-glazed photovoltaic module according to Embodiment I of the present disclosure.

### Reference numbers in the attached drawings:

1-back glass; 2-front plate glass; 3-thin-film cell stack; 31-conductive wire; 4-hollow cavity; 5-support ball; 6-spacing strip; 7-metal wire; 8-hollow tube; 9-bus bar; and 10-junction box.

### DETAILED DESCRIPTION OF THE EMBODIMENTS

Embodiments of the present disclosure are described in detail as below. Examples of the embodiments are as shown in drawings, in which same or similar reference numbers always represent same or similar elements or elements with same or similar functions. The embodiments described below with reference to the drawings are exemplary, just used for explaining the present disclosure, not construed as limiting the present disclosure.

### Embodiment I

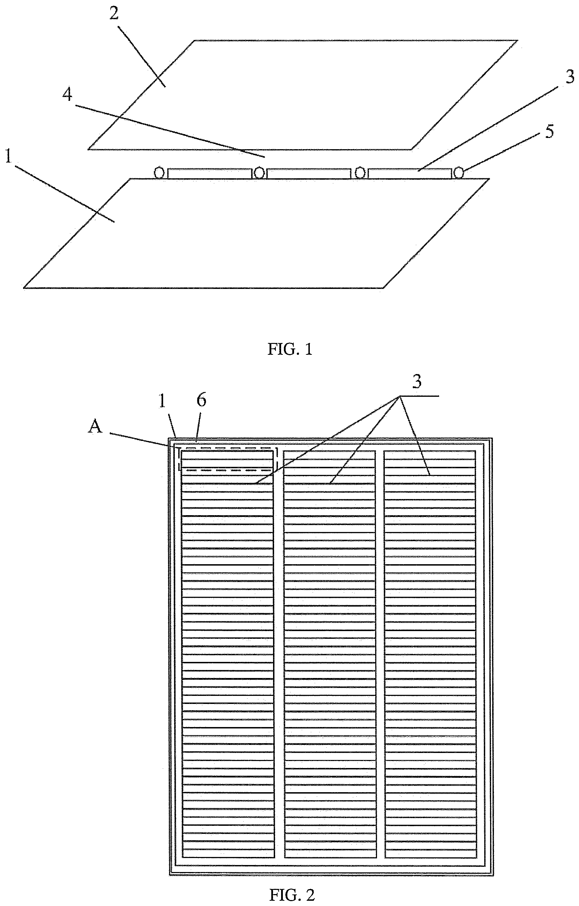

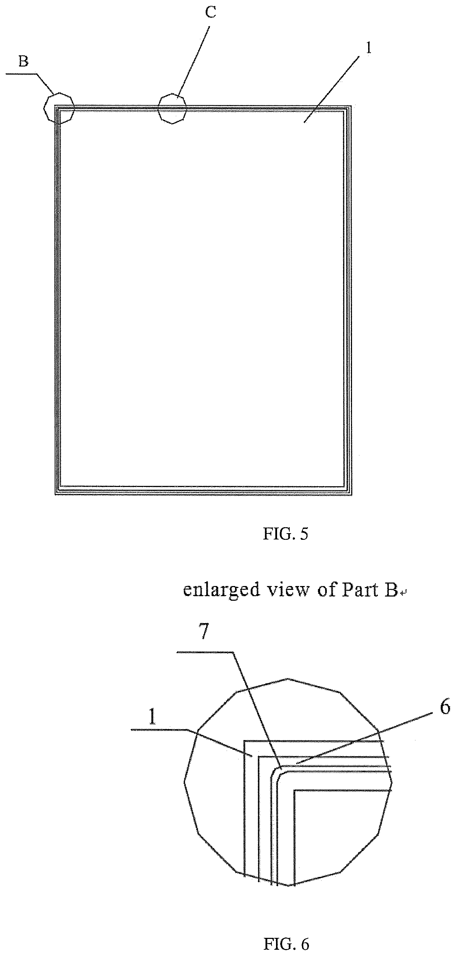

This embodiment of the present disclosure provides a thin-film double-glazed photovoltaic module, as shown in FIG. 1, which is a structural diagram of the thin-film double-glazed photovoltaic module according to Embodiment I of the present disclosure. The thin-film double-glazed photovoltaic module includes back glass 1, front plate glass 2, and a thin-film cell stack 3. A hollow cavity 4 is formed between the back glass 1 and the front plate glass 2 by means of a spacing strip 6 (not shown in FIG. 1, referring to FIG. 2), and the thin-film cell stack 3 is arranged in the hollow cavity 4. Referring to FIG. 5 and FIG. 6, the spacing strip 6 is provided with a metal wire 7, and the metal wire 7 is consistent with the spacing strip 6 in direction. The metal wire 7 may be a steel wire having a diameter of 0.5mm-1.5mm. The metal wire 7 serves as an interval between the back glass 1 and the front plate glass 2 to further protect the thin-film cell stack 3 in the hollow cavity 4, thereby preventing the thin-film cell stack 3 from being excessively squeezed.

In the thin-film double-glazed photovoltaic module provided by Embodiment I of the present disclosure, by arranging a thin-film cell stack into the hollow cavity formed between the back glass and the front plate glass, it is ensured that the thin-film cell stack is not squeezed by the back glass and the front plate glass, such that stretching or damaging the thin-film cell stack due to expansion caused by heat and contraction caused by cold of the back glass and the front plate glass is avoided, and thus the service life of the thin-film cell stack is prolonged. In the meanwhile, by arranging a metal wire in the spacing strip, the back glass can be further isolated from the front plate glass, and thus it is ensured that the thin-film cell stack in the hollow cavity is not damaged.

Preferably, the thin-film double-glazed photovoltaic module further includes a support ball 5 arranged in the hollow cavity 4.

It is to be understood that the support ball 5 is used for further supporting and isolating the back glass 1 from the front plate glass 2, wherein the material and size of the support ball 5 may be selected according to actual needs. In this embodiment, preferably, the support ball 5 is a cross-linking or thermosetting microspheric colloidal particle made from polyolefin elastomer (POE) or ethylene-vinyl acetate copolymer (EVA) and having a diameter of 2mm-4mm. When being laminated, the support ball 5 is thermally solidified onto the back glass 1.

The spacing strip 6 may be an ordinary rubber strip in the prior art. Preferably, the spacing strip 6 in this embodiment is a butyl rubber strip, which is bonded onto the back glass 1.

The metal wire 7 may be either arranged on the spacing strip 6 or arranged in the spacing strip 6. In this embodiment, the spacing strip 6 is a butyl rubber strip. The metal wire 7 is arranged when the butyl rubber strip is applied and the butyl rubber strip is not solidified. After the butyl rubber strip is not solidified, the metal wire 7 is coated and formed in the butyl rubber strip.

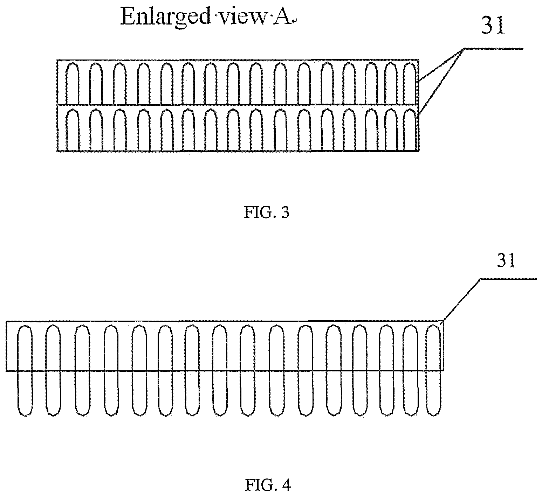

FIG. 2 is a schematic structural diagram of the thin-film double-glazed photovoltaic module with front plate glass hidden according to Embodiment I of the present disclosure; FIG. 3 is an enlarged view of Part A in FIG. 2; and FIG. 4 is a schematic structural diagram of a single thin-film cell. As shown in FIG. 2 to FIG. 4, the thin-film double-glazed photovoltaic module in this embodiment includes three thin-film cell stacks 3 in total. Each of the thin-film cell stacks 3 is formed by laminating a plurality of independent thin-film cells. Referring to FIG. 4, a conductive wire 31 on a single thin-film cell extends from a cell body and is laminated with another thin-film cell. Referring to FIG. 3, a plurality of thin-film cells are connected in series in this way to form a thin-film cell stack 3.

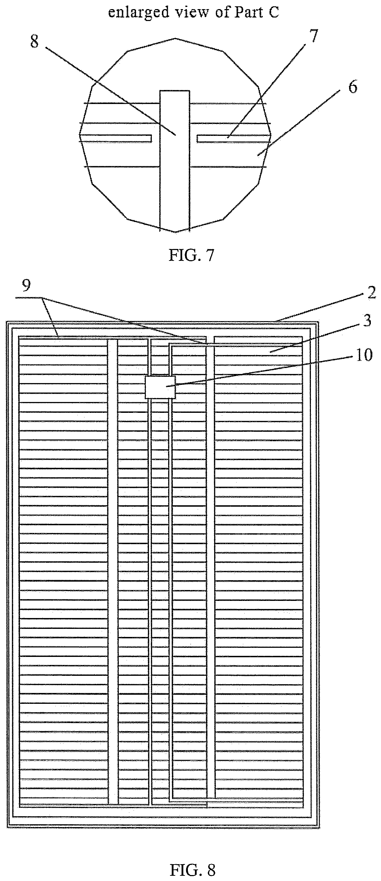

FIG. 7 is an enlarged view of Part C in FIG. 5. As shown in FIG. 5 and FIG. 7, in consideration of vacuumization and nitrogen injection operations for the hollow cavity 4 in post fabrication, there is further provided a hollow tube 8. A central axis of the hollow tube 8 is unparallel to the direction of the spacing strip 6, and ports at two ends of the hollow tube 8 are exposed to two sides of the spacing strip 6, such that a port at one end of the hollow tube 8 is positioned inside the hollow cavity 4, and a port at the other end of the hollow tube 8 is positioned outside the hollow cavity. In the process of pre-burying the hollow tube 8, only the central axis of the hollow tube 8 is unparallel to the direction of the spacing strip 6 can it be ensured that both two ends of the hollow tube 8 extend from two sides of the spacing strip 6. In the actual operation, the hollow tube 8 may be perpendicular to the direction of the spacing strip 6, and in the meanwhile the hollow tube 8 does not cross over the metal wire 7. In the specific operation, the metal wire 7 may be set to be a disconnected state, such that the hollow tube 8 passes through the disconnected location of the metal wire 7, as shown in FIG. 7. In this way, interference and abrasion between the hollow tube 8 and the metal wire 7 may be avoided, thereby avoiding air leakage, etc. To ensure the strength of the hollow tube 8, the hollow tube 8 may be a polyethylene tube having an inside diameter of 2mm and a length of 30mm.

FIG. 8 is a rear view of the thin-film double-glazed photovoltaic module according to Embodiment I of the present disclosure. Based on the above embodiments, the photovoltaic module further includes a bus bar 9 and a junction box 10. An insulating encapsulation film is arranged between a backlight surface of the thin-film cell stack 3 and the bus bar 9, one end of the bus bar 9 conductively connects to a group of the thin-film cell stacks 3 to converge electric currents of this group of the thin-film cell stacks 3, and the other end of the bus bar 9 goes through the hollow cavity 4 and then connects to the junction box 10.

The bus bar 9 may go through the hollow cavity 4 via the exit from on the back glass 1, or from a middle location or other locations of the back glass 1 according to actual needs, or from between the back glass 1 and the front plate glass 2. Correspondingly, the junction box 10 may be arranged on the back glass 1 or between the back glass 1 and the front plate glass 2 based on the location from which the bus bar 9 goes through.

### Embodiment II

Embodiment II of the present disclosure provides a method for fabricating a thin-film double-glazed photovoltaic module, which includes following steps:
Step S100: flat placing front plate glass 2, and arranging a spacing strip 6 around a side where the front plate glass 2 is upward.

The spacing strip 6 may be an ordinary rubber strip in the prior art or may be a butyl rubber strip adopted in this embodiment. A certain amount of butyl rubber is applied around the front plate glass 2 to serve as an interval between the front plate glass 2 and the back glass 1.

Step S200: placing a thin-film cell stack 3 onto the front plate glass 2, and keeping a light receiving face of the thin-film cell stack 3 facing toward the front plate glass 2.

According to actual needs, the thin-film cell stack 3 may be placed in the center of the front plate glass 2.

Step S300: covering the back glass 1 on the thin-film cell stack 3.

Step S400: laminating by a laminating machine to form the thin-film double-glazed photovoltaic module.

In this step, the laminating technology is the same as the laminating technologies in the prior art, and thus is not repeated any more herein. Preferably, vacuumization is carried out after the Step S400, and the fabrication method further includes following steps:
Step S500: vacuumizing the hollow cavity 4 between the front plate glass 2 and the back glass 1.

Preferably, operation of nitrogen injection is further included after the Step S500, that is, the fabrication method further includes following steps:
Step S600: injecting nitrogen into the hollow cavity 4. The thin-film double-glazed photovoltaic module is cooled down in the atmosphere of nitrogen.

After the thin-film double-glazed photovoltaic module is moved out of the laminating machine, one exposed end of the polyethylene tube from which nitrogen is injected is thermally sealed to ensure a sealing state inside the hollow cavity 4.

Preferably, after the Step S200 and before the Step S300, the fabrication method further includes Step S210: arranging a plurality of support balls 5 at a clearance of the thin-film cell stack 3.

The support ball 5 may be a cross-linking or thermosetting microspheric colloidal particle made from polyolefin elastomer (POE) or ethylene-vinyl acetate copolymer (EVA) and having a diameter of 2mm-4mm. After the thin-film cell stacks 3 are arranged on the front plate glass 2, the above colloidal particles are evenly spread at the clearance between the thin-film cell stacks 3. The colloidal particles are softened when laminating and come into contact with the front plate glass 2 and the back glass 1 to play a role in positioning and limiting the locations of the thin-film cell stacks 3.

### Embodiment III

Embodiment III of the present disclosure provides a method for fabricating a thin-film double-glazed photovoltaic module, which includes following steps:
A process of fabricating the thin-film cell stack 3 includes following steps:
Step S01: connecting in series and laminating a plurality of thin-film cells;
Step S02: arranging an insulating encapsulation film on a backlight surface of the laminated thin-film cells; and
Step S03: pasting a bus bar onto the insulating encapsulation film.

After the thin-film cell stack 3 is fabricated, following steps are carried out:
Step S110: flat placing the front plate glass 2, arranging a spacing strip 6 around a side where the front plate glass 2 is upward, and also placing a metal wire 7 consistent with the spacing strip 6 in direction on the spacing strip 6.
Step S120: pre-burying a hollow tube 8 into the spacing strip 6, and ensuring ports at two ends of the hollow tube 8 are exposed to two sides of the spacing strip 6, and the hollow tube 8 does not cross over the metal wire 7.
Step S200: placing the thin-film cell stack 3 onto the front plate glass 2, and keeping a light receiving face of the thin-film cell stack 3 facing toward the front plate glass 2.
Step S210: arranging a plurality of support balls 5 at a clearance of the thin-film cell stack 3.
Step S310: threading the bus bar 9 out of an exit, and then covering the back glass 1 on the thin-film cell stack 3.
Step S320: filling with glue at the exit.
Step S330: connecting the bus bar 9 to the junction box 10, and filling a seal gum onto the junction box 10.
Step S400: laminating by a laminating machine to form the thin-film double-glazed photovoltaic module.
Step S500: vacuumizing the hollow cavity 4 between the front plate glass 2 and the back glass 1.
Step S600: injecting nitrogen into the hollow cavity 4.

The above embodiments as shown in the drawings illustrate the structure, the features and the effects of the thin-film double-glazed photovoltaic module in detail, and the above embodiments are merely preferred embodiments of the present disclosure. However, the present disclosure does not limit the scope of implementation according to what is shown in the figures. Any modifications made in accordance with the conception of the present disclosure or equivalent embodiments revised as equivalent changes shall fall within the scope of protection of the present disclosure as long as they are within the specification and the spirit covered by the drawings.

### INDUSTRIAL APPLICABILITY

According to the thin-film double-glazed photovoltaic module and the fabrication method thereof provided by the present disclosure, by arranging a thin-film cell stack into the hollow cavity formed between the back glass and the front plate glass, it is ensured that the thin-film cell stack is not squeezed by the back glass and the front plate glass, such that stretching or damaging the thin-film cell stack due to expansion caused by heat and contraction caused by cold of the back glass and the front plate glass is avoided, and thus the service life of the thin-film cell stack is prolonged. For the nowadays industrialized society beset with problems of short service life and quick performance degradation of photovoltaic modules, the thin-film double-glazed photovoltaic module and a fabrication method thereof provided by the present disclosure is a urgently-needed creation.

Moreover, advantages of the industrial applicability of the present disclosure also are derived from the concrete structure of the thin-film double-glazed photovoltaic module, that is, by arranging a metal wire in the spacing strip, the back glass can be further isolated from the front plate glass, and thus it is ensured that the thin-film cell stack in the hollow cavity is not damaged. By pre-burying a hollow tube, vacuumization and nitrogen injection operations for the hollow cavity may be implemented, thereby avoiding oxidation of the thin-film cell stack. By arranging a support ball in the hollow cavity, the back glass is further isolated from the front plate glass, and thus it is ensured that the thin-film cell stack in the hollow cavity is not damaged. Thus, compared with the prior art in which tension and compression are caused to film layers of a CIGS thin-film cell due to influences of temperature variation on encapsulation layers and glass, the thin-film double-glazed photovoltaic module having the advantages of tension and compression resistance and oxidation resistance or the like and the fabrication method thereof have better industrial applicability.

## Claims

1. A thin-film double-glazed photovoltaic module, comprising: back glass, front plate glass, and a thin-film cell stack; wherein a hollow cavity is formed between the back glass and the front plate glass by means of a spacing strip, the thin-film cell stack is arranged in the hollow cavity; and the spacing strip is provided with a metal wire, and the metal wire is consistent with the spacing strip in direction.

2. The thin-film double-glazed photovoltaic module according to claim 1, wherein the spacing strip is a butyl rubber strip.

3. The thin-film double-glazed photovoltaic module according to claim 2, wherein the metal wire coats inside the butyl rubber strip.

4. The thin-film double-glazed photovoltaic module according to claim 3, wherein the metal wire is a steel wire having a diameter of 0.5mm-1.5mm.

5. The thin-film double-glazed photovoltaic module according to claim 3, further comprising a hollow tube, wherein a central axis of the hollow tube is unparallel to the direction of the spacing strip, and ports at two ends of the hollow tube are exposed to two sides of the spacing strip, such that a port at one end of the hollow tube is positioned inside the hollow cavity, and a port at the other end of the hollow tube is positioned outside the hollow cavity.

6. The thin-film double-glazed photovoltaic module according to any one of claims 3-5, wherein the hollow tube passes through the spacing strip, and the hollow tube does not cross over the metal wire.

7. The thin-film double-glazed photovoltaic module according to claim 6, wherein the hollow tube has an inside diameter of 2mm and a length of 30mm.

8. The thin-film double-glazed photovoltaic module according to claim 7, wherein a material of the hollow tube is polyethylene.

9. The thin-film double-glazed photovoltaic module according to any one of claims 1-5, further comprising a support ball arranged in the hollow cavity.

10. The thin-film double-glazed photovoltaic module according to claim 9, wherein the support ball is a cross-linking or thermosetting microspheric colloidal particle made from polyolefin elastomer (POE) or ethylene-vinyl acetate copolymer (EVA) and having a diameter of 2mm-4mm.

11. The thin-film double-glazed photovoltaic module according to any one of claims 1-5, further comprising a bus bar and a junction box, wherein an insulating encapsulation film is arranged between a backlight surface of the thin-film cell stack and the bus bar, one end of the bus bar conductively connects to a group of the thin-film cell stacks, and another end of the bus bar goes through the hollow cavity and then connects to the junction box.

12. The thin-film double-glazed photovoltaic module according to claim 11, wherein the bus bar goes out of the hollow cavity via an exit, the exit is positioned on the back glass, or the exit is positioned between the back glass and the front plate glass.

13. A method for fabricating a thin-film double-glazed photovoltaic module, comprising following steps:
Step S100: flat placing front plate glass, and arranging a spacing strip around a side where the front plate glass is upward;
Step S200: placing a thin-film cell stack onto the front plate glass, and keeping a light receiving face of the thin-film cell stack facing toward the front plate glass;
Step S300: covering the back glass on the thin-film cell stack; and
Step S400: laminating by a laminating machine to form the thin-film double-glazed photovoltaic module.

14. The method for fabricating a thin-film double-glazed photovoltaic module according to claim 13, wherein the Step S300 specifically comprises:
Step S110: flat placing the front plate glass, arranging a spacing strip around a side where the front plate glass is upward, and also placing a metal wire consistent with the spacing strip in direction on the spacing strip.

15. The method for fabricating a thin-film double-glazed photovoltaic module according to claim 14, wherein after the Step S110, the method further comprises:
Step S120: pre-burying a hollow tube into the spacing strip, and ensuring ports at two ends of the hollow tube are exposed to two sides of the spacing strip, and the hollow tube does not cross over the metal wire.

16. The method for fabricating a thin-film double-glazed photovoltaic module according to any one of claims 13-15, wherein before the Step S100, the fabrication method further comprises a process of fabricating a thin-film cell stack, specifically comprising:
Step S01: connecting in series and laminating a plurality of thin-film cells;
Step S02: arranging an insulating encapsulation film on a backlight surface of the laminated thin-film cells; and
Step S03: pasting a bus bar onto the insulating encapsulation film.

17. The method for fabricating a thin-film double-glazed photovoltaic module according to any one of claims 13-15, wherein the Step S300 specifically comprises:
Step S310: threading the bus bar out of an exit, then covering the back glass on the thin-film cell stack;
Step S320: filling with glue at the exit; and
Step S330: connecting the bus bar to the junction box, and filling a seal gum onto the junction box.

18. The method for fabricating a thin-film double-glazed photovoltaic module according to any one of claims 13-15, wherein after the Step S400, the method further comprises:
Step S500: vacuumizing the hollow cavity between the front plate glass and the back glass.

19. The method for fabricating a thin-film double-glazed photovoltaic module according to claim 18, wherein after the Step S500, the method further comprises Step S600: injecting nitrogen into the hollow cavity.

20. The method for fabricating a thin-film double-glazed photovoltaic module according to any one of claims 13-15, wherein after the Step S200 and before the Step S300, the fabrication method further comprises:
Step S210: arranging a plurality of support balls at a clearance of the thin-film cell stack.
